**Europäisches Patentamt**

**European Patent Office**

**Office européen des brevets**

(19)

(11) Veröffentlichungsnummer: **0 006 470**
**B1**

(12) **EUROPÄISCHE PATENTSCHRIFT**

(45) Veröffentlichungstag der Patentschrift: 03.02.82

(51) Int. Cl.³: **G 06 F 11/20,** G 11 C 19/28

(21) Anmeldenummer: **79101701.5**

(22) Anmeldetag: **01.06.79**

(54) **Ladungskopplungsspeicher und Verfahren zu seiner Herstellung.**

(30) Priorität: **30.06.78 US 920934**

(43) Veröffentlichungstag der Anmeldung:
**09.01.80 Patentblatt 80/1**

(45) Bekanntmachung des Hinweises auf die Patenterteilung:
**03.02.82 Patentblatt 82/5**

(84) Benannte Vertragsstaaten:
**DE FR GB**

(56) Entgegenhaltungen:
DE - A - 2 817 134
FR - A - 2 316 699
US - A - 3 585 607
US - A - 3 921 156
US - A - 3 986 179
US - A - 3 990 058
US - A - 4 020 469
US - A - 4 024 509
US - A - 4 047 163
US - A - 4 051 354
US - A - 4 096 580

(73) Patentinhaber: **International Business Machines Corporation**
**Armonk, N.Y. 10504 (US)**

(72) Erfinder: **Jambotkar, Chakrapani Gajanan**
**154 Hosner Mountain Road**
**Hopewell Junction, NY 12533 (US)**

(74) Vertreter: **Rudolph, Wolfgang**
**Schönaicher Strasse 220**
**D-7030 Böblingen (DE)**

(56) Entgegenhaltungen:
**IBM TECHNICAL DISCLOSURE BULLETIN, Vol. 17, Nr. 1, Juni 1974, Armonk, US, COOK & SCHUSTER "Memory system fabrication using laser formed connections", Seiten 245—247**

**IBM TECHNICAL DISCLOSURE BULLETIN, Vol. 18, Nr. 4, September 1975, Armonk, US, LIN et al.: "Redundancy scheme for major/minor loop bubble memories", Seiten 1274—1275**

**IBM TECHNICAL DISCLOSURE BULLETIN, Vol. 20, Nr. 5, Oktober 1977, Armonk, US, PALOUNEK: "Self-repairing by pseudoduplication", Seiten 1875—1876**

**0 006 470**

(56) Entgegenhaltungen:
IBM TECHNICAL DISCLOSURE BULLETIN, Vol.
21, Nr. 2, Juli 1978, Armonk, US,
AICHELMANN: "Dynamic SPC array configuration",
Seiten 615—616

IEEE INTERNATIONAL SOLID-STATE CIRCUITS
CONFERENCE, 17. Februar 1977, New York, US,
ELMER et al.: "Fault-tolerant 92160 bit
multiphase CCD memory", Digest of technical
Papers", Seiten 116—117

# Ladungskopplungsspeicher und Verfahren zu seiner Herstellung

Die Erfindung betrifft einen Ladungskopplungsspeicher nach dem Oberbegriff des Anspruchs 1 und ein Herstellungsverfahren nach dem Oberbegriff des Anspruchs 3.

Ladungskopplerstrukturen und ihre Verwendung als Speicher von Datenverarbeitungssystemen sind allgemein bekannt. Bei einer seriellen-parallelen-seriellen Konfiguration beispielsweise, wird ein Strom von Datenbits in ein serielles Schieberegister aus Ladungskopplungselementen (CCD) eingegeben und von dort parallel in einen parallelen Speicher übertragen. Die Daten können dann parallel durch den Speicher geschoben und in ein serielles Ausgaberegister gegeben werden, von wo sie als serieller Bitstrom wieder ausgegeben werden.

Der parallele Teile enthält ein große Matrix von Speicherstellen, die jeweils als Potentialtopf zum Speichern eines Paketes von Ladungsträgern dienen. Wegen der großen Anzahl von Speicherplätzen in vielen Zeilen und Spalten der Matrix besteht eine große Wahrscheinlichkeit, daß wenigstens eine Stelle defekt ist.

Dadurch werden der Ausstoß der Fertigung natürlich wesentlich heruntergesetzt und andererseits die Kosten für Ladungskopplungselemente in die Höhe getrieben. Da die Kosten pro gespeichertes Bit ein kritischer Faktor für die Entscheidung sind, ob Ladungskopplungselemente mit anderen Speichertechnologien konkurrieren können, ist es von lebenswichtiger Bedeutung, den Ausstoß von Ladungskopplungselementen in der Fertigung auf jede nur mögliche Weise zu verbessern.

Bei den Bemühungen, den Ausstoß von Ladungskopplungselementen und anderen Halbleiterspeicherchips zu verbessern, wurden zahlreiche fehlertolerante Fehlerschemata entwickelt.

Bei Ladungskopplungsspeichern (z.B. US—A—3 986 179) finden sich viele Schemata für Fehlertoleranz mit mäßiger Redundanz, d.h., wenn eine defekte Zelle vorliegt, braucht anstelle einer ganzen Gruppe oder eines ganzes Blockes nur eine redundante Zellenzeile oder Zellenspalte vorgesehen zu werden. Hierbei haldelt es sich jedoch um Adreßübersetzungsschemata für Speicher, die beliebig adressiert werden können, im Gegensatz zum seriellen Betrieb der Ladungskopplungsspeicher, Außerdem bringen die Schemata alle Nachteile der Kosten und Komplexität mit sich, die mit zusätzlicher Logikschaltung für die Adreßübersetzung von den Adressen der fehlerhaften Bits auf die Adressen guter Bits verbunden sind.

Außerdem ist noch durch die US—A—4 024 509 ein Ladungskopplungsspeicher bekannt, bei dem ein Strom von Datenbits in ein Schieberegister eingegeben wird, das aus Ladungskopplungselementen besteht und das mit einem parallel ansteuerbaren Speicher zur Übertragung von Daten in diesen Speicher verbunden ist, wobei Speicherplätze innerhalb des parallelen Speichers defekt sind. Auch bei dieser Einrichtung werden redundante Spalten im parallelen Speicher vorausgesetzt, da fehlerhafte Spalten bzw. Ebenen eliminiert werden und die dafür bestimmten Informationen in benachbarte Spalten bzw. Ebenen eingeschrieben werden. Da jede Ebene aus mehreren parallelen Registern besteht, werden bei der Überbrückung fehlerhafter Ebenen jeweils Gruppen oder Sätze serieller Register mit Ladungsspeicherplätzen, die einer defekten Spalte entsprechen, kurgeschlossen. Aus dieser US—Patentschrift ist außerdem bekannt, vor der Fertigstellung des Ladungskopplungsspeichers einen Prüfvorgang einzuschalten, mit dem festgestellt wird, ob der parallele Speicherteil Spalten oder Ebenen mit defekten Bitstellen enthält. In einem Abschlußprozeß werden danach die defekten Spalten aus den Flußbahnen der übertragenen Ladungspackete herausgenommen und statt dessen eine entsprechende Anzahl redundanter Spalten eingesetzt, wobei das Umschalten durch Kurzschließen bzw. Abtrennen der defekten Spalten und das Verbinden der redundanten Spalten mit Hilfe einer Laserstrahloperation erfolgen.

Der Erfindung liegt deshalb die Aufgabe zugrunde, eine verbesserte Struktur für einen integrierten Ladungskopplungsspeicher in serieller-paralleler-serieller Schaltung anzugeben, bei dem der Austausch defekter Speicherplätze sowie dessen Herstellung besonders einfach ist, so daß eine signifikante Verbesserung des Fertigungsausstoßes erreicht wird.

Die Aufgabe wird erfindungsgemäß durch die im Patentanspruch 1 angegebenen dieshmale gelöst. Eine weitere Ausgestaltung der Lösung ist im Patentanspruchs 2 charakterisiert.

Außerdem ist im Patentanspruchs 3 ein vorteilhaftes Verfahren zur Herstellung, insbesondere zum Speicherstellenersatz mit Hilfe von Laserstrahlen angegeben.

Bevor die Herstellung des Chips abgeschlossen wird, wird in einer Prüfung festgestellt, ob der parallele Teil Spalten mit einer oder mehreren schlechten Bitstellen enthält, d.h., mit defekten Ladungsspeicherpunkten oder anderen Fehlern, die die Spalte unannehmbar machen.

Wenn derartige defekte Spalten in der Prüfung nicht ermittelt werden, wird die Fertigung des Chips auf übliche Weise beendet. Wenn die Prüfung jedoch eine oder mehrere defekte Spalten zeigt, kann die Fertigung des Chips nach dem erfindungsgemäßen Verfahren weitergeführt werden, unter der Voraussetzung, daß die Anzahl defekter Spalten nicht größer ist als die Anzahl der ursprünglich im Chip vorgesehenen zusätzlichen redundanten Spalten.

Der Kurzschlußeffekt wird erreicht durch Verbindung aller Gate-Elektroden der Gruppe mit einer Kreuzenden Taktphasenleitung. Bei einer vierphasigen Anordnung werden beispielsweise die normalen Verbindungen der Gate-Elektroden mit den Phasen 2, 3 und 4 und ihren entsprechenden Taktphasenleitungen durch einen Laserstrahl oder eine andere geeignete Einrichtung getrennt und stattdessen mit der Taktleitung der Phase 1 ebenfalls per Laserstrahl oder eine andere geeignete Einrichtung verbunden.

Demzufolge liegen alle vier Ladungsspeicherplätze sowie der der Elektrode der Phase 1 der benachbarten Gruppe entsprechende Platz auf demselbem Potential und bilden so einen größeren Potentialtopf, wodurch sich alle fünf Speicherplätze zu einem zusammenhängenden größeren Speicherplatz mischen. Wenn hinterher das Taktsignal auf Phase 2 angelegt wird, werden die Ladungspakete von diesem größeren gemischten Speicherplatz in den Speicherplatz übertragen, der dem Gate der Phase 2 in der nächsten Platzgruppe entspricht, wodurch effektiv die erste Gruppe von Speicherplätzen, in der die Anschlüsse der Gate-Elektroden verändert wurden, kurzgeschlossen wird.

Bei der nachfolgenden Übertragung der Zeile von Ladungspaketen aus dem seriellen Eingabeteil in die erste Zeile des parallelen Abschnittes enthält die umgangene Gruppe von Speicherplätzen des seriellen Eingabeteiles keine Ladungspakete, und somit können auch keine Ladungspakete in die erste Gruppe der defekten Spalte übertragen werden, wodurch diese effektiv umgangen wird.

Für jede für den parallelen Teil vorgesehene zusätzliche redundante Spalte müssen serielle Eingabe- und Ausgabeteile mit entsprechenden zusätzlichen Gruppen von Ladungsspeicherplätzen vorgesehen werden. In einer vierphasigen Anordnung beispielsweise, muß jeder serielle Teil vier zusätzliche Plätze für jede redundante Spalte im parallelen Teil haben.

Ein Ausführungsbeispiel der Erfindung ist in den beigefügten Zeichnungen dargestellt und wird anschließend näher beschrieben.

Es zeigen:

Fig. 1 schematisch einen Ladungskopplungsspeicher in serieller-paralleler-serieller Konfiguration herkömmlicher Art,

Fig. 2 schematisch dieselbe Konfiguration mit einer zusätzlichen redundanten Spalte im parallelen Teil und zusätzlichen redundanten Speicherplätzen im seriellen Teil nach dem Erfindungsgedanken,

Fig. 3 eine schematische Schnittansicht des seriellen Eingabe- und Ausgabeteiles zur Darstellung der Schaltungsanordnung für den Kurzschluß einer Bitgruppe von Gate-Elektroden zur Umgehung der entsprechenden defekten Spalte des parallelen Teiles,

Fig. 4 ein Potentialdiagramm mit einem ersten Ladungspaket in einem Potentialtunnel an einer normalen Bitgruppe serieller Speicherplätze und einem zweiten Ladungspaket in einem vergrößerten Potentialtopf, der sich über einen kurzgeschlossenen Satz von Speicherplätzen erstreckt, wie sie zur Taktphase 1 erscheinen.

Fig. 5 ein Potentialdiagramm ähnlich Fig. 4 mit zwei Potentialtöpfen und den entsprechenden Ladungspaketen, die auf die betreffenden benachbarten Plätze zur Taktzeit der Phase 2 übertragen werden,

Fig. 6 eine Schnittansicht durch einen Teil des seriellen Bereichs vor dem Kurzschlußschnitt und der Kurzschlußverbindung,

Fig. 7 eine ähnliche Schnittansicht wie Fig. 6, in der die Schnitte und Verbindungen nach dem Erfindungsgedanken effektiv die Gruppe serieller Speicherplätze kurzschließen, die zu einer defekten Spalte im parallen Teil gehören, so daß dieser umgangen wird,

Fig. 8 eine schematische Draufsicht auf die Anordnung der Metall- und Polysiliciumleitungen, die zu zwei seriellen Abschnitten und einem dazwischenliegenden parallelen Abschnitt gehören,

Fig. 9 eine vertikale Schnittansicht entlang der Linie 9—9 in Fig. 8,

Fig. 10 eine vertikale Schnittansicht entlang der Linie 10—10 in Fig. 8 und

Fig. 11 eine vertikale Schnittansicht entlang der Linie 11—11 in Fig. 8.

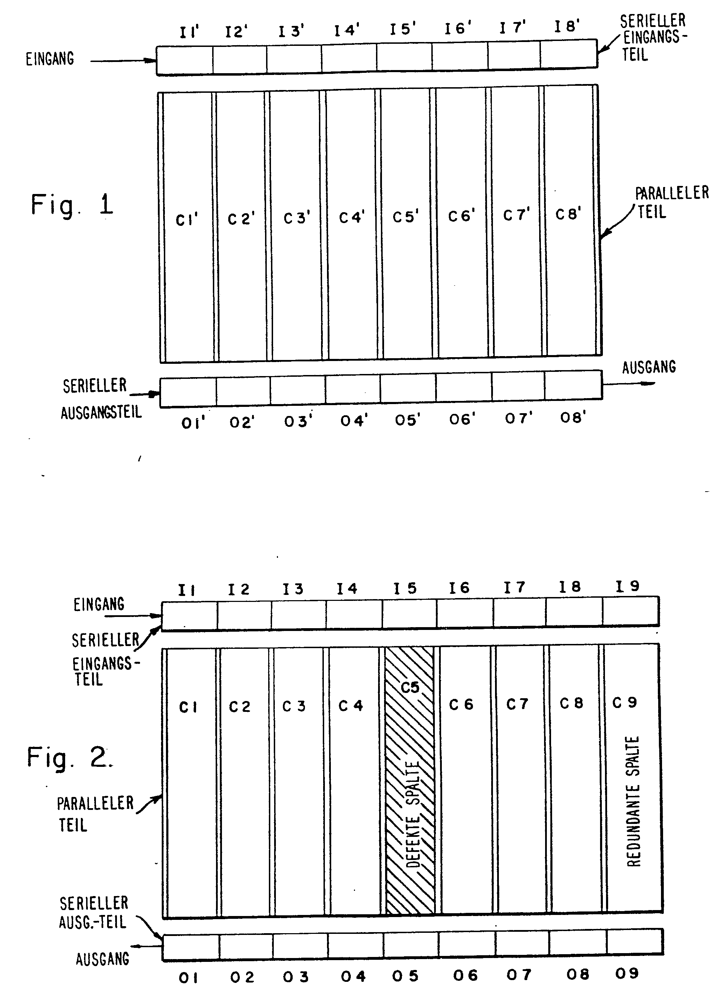

In Fig. 1 ist eine herkömmliche seriell-parallel-serielle Konfiguration von Ladungskopplungselementen gezeigt. Vorgesehen ist ein serieller Eingangsteil mit acht Bitsätzen von Speicherstellen, wobei die einzelnen Bitsätze mit I1' bis I8' bezeichnet sind und einem Datenbit entsprechen. In der dargestellten Vier-Phasen-Anordnung besteht z.B. jeder Bitsatz aus vier Ladungspaket-Speicherstellen. Während einer Taktphase ist in nur einer der vier Speicherstellen ein Ladungspaket gespeichert. In der Praxis kann jeder serielle Bitteil natürlich wesentlich mehr als acht Sätze solcher Speicherstellen haben. Am linken Ende des seriellen Eingangsteiles ist der Eingangsanschluß, durch den ein serieller Strom von Datenbits in den seriellen Eingangsteil geleitet wird.

Neben dem seriellen Eingangsteil liegt der parallele Teil, dieser ist in der Zeichnung der Klarheit halber aber in einem Abstand dargestellt. Der parallele Teil besteht aus acht Kanälen oder Spalten, die in der Zeichnung vertikal verlaufen und mit C1' bis C8' bezeichnet sind. Sie bilden eine Matrix aus Zeilen und Spalten von Speicherstellen, wobei jede Spalte eine Bahn für die Ladungsträgerpakete bildet, die der Reihe nach von einer Speicherstelle des seriellen Eingangsteiles zu einer entsprechenden Speicherstelle des seriellen Ausgangsteiles durchflossen wird.

Das serielle Ausgangteil ist ähnlich aufgebaut wie das serielle Eingangsteil. Das serielle Ausgangsteil enthält ebenfalls acht Bitsätze von Speicherzellen mit den Bezeichnungen O1' bis O8'. Jeder Satz von Speicherstellen entspricht einer Spalte C1' bis C8' des parallelen Teils.

Die Arbeitsweise der in Fig. 1 dargestellten herkömmlichen Konfiguration wird nur summarisch beschrieben. Ein serieller Strom von Ladungspaketen wird seriell verschoben, bis jedes Ladungspaket in einem der Bisätze I1' bis I8' an den Speicherstellen des seriellen Eingabeteiles gespeichert ist. Diese Ladungspakete werden dann parallel in die erste Zeile des parallelen Teiles und dann durch diesen hindurch in den seriellen Ausgabeteil übertragen. Während dieses Prozesses werden aufeinanderfolgende Reihen von Ladungspaketen in ähnlicher Weise durch den parallelen Teil vom seriellen Eingabeteil zum seriellen Ausgabeteil übertragen. Wenn jede Zeile von Ladungspaketen die letzte Zeile von Speicherstellen im parallelen Teil erreicht, wird diese Zeile parallel in den seriellen Ausgabeteil übertragen, und von dort werden die Ladungspakete seriell zum Ausgangsanschluß geschoben.

Da in einer praktisch gebauten Ausführung dieser seriell-parallel-seriellen Konfiguration von Ladungskopplungselementen der parallele Teil viele Spalten und Zeilen um faßt und so eine große Matrix von Ladungsspeicherstellen bildet, besteht einige Wahrscheinlichkeit, daß eine oder mehrere dieser Ladungsspeicherstellen defekt sind. In diesem Fall ist das ganze in herkömmlicher Technik aufgebaute Ladungskopplungschip nutzlos und muß verschrottet werden. Dadurch geht der Ausstoß während der Fertigung wesentlich herunter und die Kosten steigen.

In der vorliegenden Erfindung wird dieses Problem durch eine neuartige Konfiguration gelöst, in der defekte Spalten des parallelen Teiles so umgangen werden können, daß Elemente mit defekten Speicherstellen trotzdem benutzt werden können und nicht verschrottet zu werden brauchen, so daß der Austoß wesentlich erhöht und die Herstellungskosten reduziert werden.

Diese neuartige Anordnung ist schematisch in Fig. 2 gezeigt und besteht aus einem seriellen Eingabeteil, einem parallelen Mittelteil und einem seriellen Ausgabeteil. Der serielle Eingabeteil der Fig. 2 ist gegenüber der Anordnung der Fig. 1 mit einem zusätzlichen Satz von Ladungsspeicherplätzen versehen, d.h., er hat neun solcher Sätze mit den Bezeichnungen I1 bis I9. Ähnlich weist der parallele Teil in Fig. 2 gegenüber dem in Fig. 1 eine zusätzliche redundante Spalte auf. Die neun Spalten oder Kanäle sind bezeichnet mit C1 bis C9. Das serielle Ausgabeteil der Fig. 2 hat ebenfalls eine zusätzliche redundante Spalte von Speicherplätzen mit den Bezeichnungen O1 bis O9.

Die Gesamtarbeitsweise der Erfindung wird zuerst summarisch im Zusammenhang mit Fig. 2 beschrieben. Die Einheit wird auf herkömmliche Art hergestellt bis unmittelbar vor dem Quarz-Passivierungsschutz. An diesem Punkt wird der Herstellungsprozeß unterbrochen und in einer Prüfung des Gerätes festgestellt, ob der parallele Teil Spalten mit einem oder mehreren defekten Speicherplätzen oder anderen Fehlern enthält, die die betreffende Spalte unbrauchbar machen. Werden bei der Prüfung keine derartigen Fehler festgestellt, wird die Herstellung des Chips wie üblich zu Ende geführt. Wenn die Prüfung jedoch zeigt, daß eine oder mehrere Spalten defekt sind, wird der Herstellungsprozeß insofern geändert, als die defekten Spalten effektiv umgangen und dafür nach Bedarf eine oder mehrere redundante Spalten eingesetzt werden. Diese Umgehung erfolgt durch Kurzschließen eines Satzes serieller Register-Ladungsspeicherplätze, die jeder defekten Spalte entsprechen.

In Fig. 2 ist beispielsweise die Spalte C5 im parallelen Teil defekt dargestellt. Wenn bei der Prüfung diese Fehler festgestellt werden, werden die entsprechenden Sätze von Ladungsspeicherstellen I5 im seriellen Eingabeteil und im seriellen Ausgabeteil in einer noch zu beschreibenden Art so kurzgeschlossen, daß die defekte Spalte C5 umgangen wird, d.h., die normalerweise im Satz I5 gespeicherten Ladungspakete werden stattdessen auf den nächsten Satz I6 des seriellen Eingabeteiles übertragen, so daß dieser effektiv für den Satz I5 eingesetzt w rd. Die nachfolgenden Sätze I7, I8 und I9 speichern dann die Ladungspakte, die eigentlich in I6, I7 und I8 gespeichert würden. Das normalerweise im Satz I8 gespeicherte erste Ladungspaket wird beispielsweise in dem zusätzlichen redundanten Satz I9 gespeichert.

In dem Augenblick, in dem die Zeile von Ladungsspeicherpaketen parallel in die erste Zeile des parallelen Abschnittes übertragen wird, enthält der Speichersatz I5 kein Ladungspaket und somit wird nichts in die defekte Spalte C5 übertragen. Das erste Ladungspaket im seriellen Datenbitstrom wird im Satz I9 zum Zeitpunkt der Übertragung gespeichert und läuft somit in den ersten Speicherplatz der zusätzlichen redundanten Spalte C9 des parallelen Teiles. Das erste Ladungspaket läuft dann durch die Spalte C9 bei der Übertragung jeder nachfolgenden Zeile in den seriellen Ausgabeteil und wird dann in den zusätzlichen redundanten Satz O9 des seriellen Ausgabeteiles während der parallelen Übertragung der Zeile von Ladungspakten übertragen.

Wenn also eine Spalte im parallelen Teil defekt ist, kann sie umgangen und eine zusätzliche redundante Spalte an ihrer Stelle benutzt werden, so daß das Chip betriebsbereit bleibt. Obwohl der Einfachheit und Klarheit halber in Fig. 2 nur eine zusätzliche redundante Spalte und die entsprechenden zusätzlichen Sätze von Speicherplätzen in den seriellen Teilen gezeigt sind, kann diese Redundanz natürlich in vielen Exemplaren vorliegen. Das bedeutet, daß jede gewünschte Zahl von zusätzlichen redundanten Spalten zusammen mit entsprechenden Sätzen von Speicherplätzen im seriellen Eingabe- und Ausgabeteil vorgesehen werden kann und so Einheiten mit mehreren defekten Spalten unter der Voraussetzung korrigiert werden können, daß die Anzahl der zusätzlichen redundanten Spalten mindestens so groß ist wie die Anzahl der defekten Spalten.

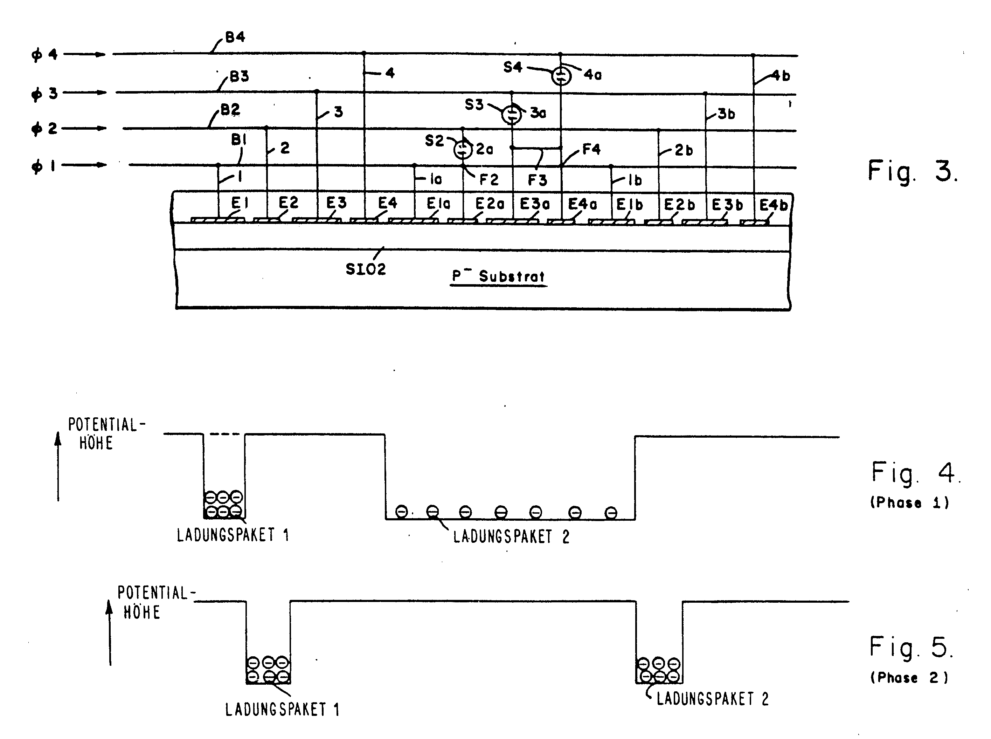

In Fig. 3 ist schematisch die Schaltung zum Kurzschließen des Bitsatzes von Speicherplätzen im seriellen Teil gezeigt, die einer defekten Spalte im parallelen Teil entsprechen. Nach der Darstellung hat das Substrat die Leitfähigkeit P⁻, andere Leitfähigkeiten können jedoch ebenso eingesetzt werden. Die Oberfläche des Substrates ist mit einer Isolationsschicht aus Siliciumdioxid versehen. Darüber liegen die Gate-Elektroden, die die Potentialköpfe zum Einfangen der Ladungsträgerpakete zwecks Speicherung bilden. Der erste Satz von Gate-Elektroden ist bezeichnet mit E1, E2, E3, E4, der zweite Satz mit E1a, E2a, E3a, E4a und dritte Satz mit E1b, E2b, E3b, E4b.

Die Gate-Elektroden E1, E1a, E1b sind durch entsprechende Leitungen 1, 1a, 1b mit der Sammelleitung B1 verbunden, an die zur Phasenzeit 1 a Taktsignal Ø angelegt wird. Entsprechend sind die Gate-Elektroden E2, E2a, E2b mit der Sammelleitung B2 verbunden, an die zur Phasenzeit 2 das Taktsignal Ø2 angelegt wird. Die Gate-Elektroden E3, E3a, E3b sind normalerweise mit den entsprechenden Leitungen 3, 3a, 3b an die Sammelleitung B3 angeschlossen, an die zur Phasenzeit 3 das Taktimpulssignal Ø3 angelegt wird. Die Gate-Elektroden E4, E4a, E4b sind normalerweise über entsprechende Leitungen 4, 4a, 4b mit der Sammelleitung B4 verbunden, an die zur Phasenzeit 4 das Taktimpulssignal Ø4 angelegt wird.

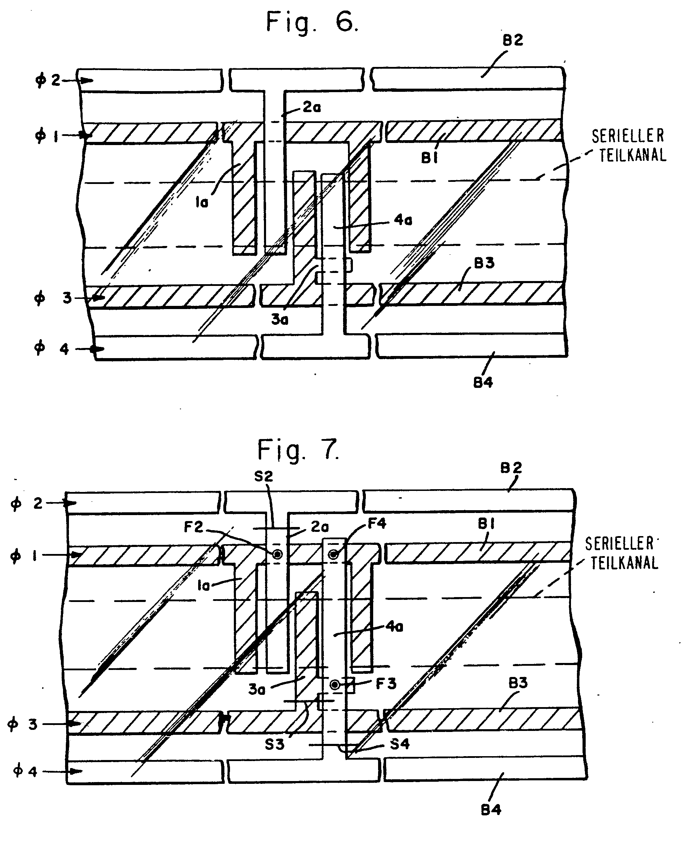

Zur Illustration des Verfahrens sei angenommen, daß die mittleren Speicherplätze, gebildet durch die Gate-Elektroden E1a, E2a, E3a, E4a zu einer defekten Spalte des parallelen Teiles gehören und daher, wie nachfolgend beschrieben, kurzgeschlossen werden, um die defekte Spalte zu umgehen. Die normalerweise die Gate-Elektrode E2a mit der Sammelleitung B2 verbindende Leitung 2a wird abgeschnitten oder getrennt, wie es durch das Zeichen bei S2 dargestellt ist. Dieser Schnitt kann wie üblich mit einem Laserstrahl während der Herstellung erfolgen, nachdem in der Prüfung festgestellt wurde daß die Spalte defekt ist. Der noch mit der Gate-Elektrode E2a verbundene Teil der Leitung 2a wird dann bei F2 mit der Sammelleitung B1 wie üblich mit Hilfe des Laserstrahls verbunden. Die wirkliche physikalische Lage des Schnittes S2 und des Verbindungspunktes F2 werden im einzelnen noch im Zusammenhang mit Fig. 7 beschrieben. Auf ähnliche Weise wird die normalerweise die Gate-Elektrode E3a mit der Sammelleitung B3 verbundene Leitung 3a bei S3 geschnitten. Derjenige Teil der Leitung 3a, der noch mit der Elektrode E3a verbunden ist, wird an die Leitung 4a an der symbolisch dargestellten Stelle F3 angeschlossen. Die normalerweise die Elektrode E4a mit der Sammelleitung B4 verbindende Leitung 4a wird bei S4 geschnitten, und der noch mit der Gate-Elektrode E4a verbundene Teil der Leitung 4a wird bei F4 an die Sammelleitung B1 angeschlossen.

Arbeitsweise und Wirkung der in Fig. 3 gezeigten Kurzschlußmodifikation werden nun im Zusammenhang mit den Potentialdiagrammen der Fign. 4 und 5 beschrieben. Das Diagramm in Fig. 4 zeigt die Größe des Potentiales und die resultierenden Potentialtöpfe zur Phasenzeit 1. Das an die Gate-Elektrode E1 angelegte Taktsignale Ø1 bildet einen Potentialtopf neben der Elektrode und speichert so darin Minoritätsladungsträger, die durch ein eingekreistes Minuszeichen dargestellt und Ladungsträgerpaket 1 genannt werden. Fig. 5 zeigt die Potentialgrößen an den verschiedenen Gate-Elektroden zur Phasenzeit 2. Das an die zweite Gate-Elektrode E2 angelegte Taktsignal bildet darunter einen Potentialtopf und die Größe des Potentiales entspricht dem der ersten Gate-Elektrode E1 und wurde so gesenkt, daß der früher unter der ersten Gate-Elektrode E1 befindliche Potentialtopf mit dem Ladungspaket 1 darin effektiv so übertragen wurde, daß er neben und unter der zweiten Gate-Elektrode E2 liegt. Zur Phasenzeit 3 werden der Potentialtopf und das Ladungspaket 1 darin in eine Position unmittelbar unter der Gate-Elektrode E3 übertragen, und auf ähnliche Weise werden der Potentialtopf und das Ladungspaket 1 zur Phasenzeit 4 in den Speicherplatz übertragen, der durch die Gate-Elektrode E4 gebildet wird. Bisher handelt es sich im Betrieb also um eine durchaus herkömmliche vierphasige nicht verschachtelte serielle-parallele-serielle Konfiguration.

Die Schnitte S2, S3, S4 und die entsprechenden Verbindungen F2, F3 und F4 schließen den zweiten Bitsatz von Speicherplätzen kurz, gebildet durch die Gate-Elektroden E1a, E2a, E3a und E4a und umgehen dadurch die entsprechende defekte Spalte im parallelen Teil, wie nachfolgend beschrieben wird. Zur Phasenzeit 1 wird das normalerweise nur an die erste Gate-Elektrode des Satzes angelegte Taktsignal Ø1 durch die in Fig. 3 dargestellten Schnitte und Verbindungen für den mittleren Teil von Speicherplätzen an alle vier Elektroden E1a, E2a, E3a, E4a des mittleren Satzes angelegt. Demzufolge bilden die Bereiche unter diesen vier Elektroden einen gemischten großen Potentialtopf, wie er in Fig. 4 gezeigt ist. Dieser Potentialtopf mischt sich auch mit dem unter der Elektrode E1b des dritten Satzes der Speicherplätze gebildeten Potentialtopf. Nach Darstellung in Fig. 4 kann dieser unter fünf zusammenhängenden Gate-Elektroden verlaufende Potentialtopf ein Ladungspaket speichern, das in Fig. 4 als Ladungspaket 2 bezeichnet ist.

Aus Fig. 5 ist zu ersehen, daß beim Anlegen des Taktsignales Ø2 zur Phasenzeit 2 das früher im großen Potentialtopf unter den fünf Gate-Elektroden E1a, E2a, E3a, E4a, E1b liegende Ladungspaket 2 in den Potentialtopf übertragen wird, der unter der zweiten Gate-Elektrode E2b des dritten Satzes von Speicherstellen, dargestellt in Fig. 3, liegt. Wenn die Schnitte S2, S3, S4 und die Verbindungen F2, F3, F4 nicht vorgenommen worden wären, würde das Ladungspaket 2 normalerweise in dem Potentialtopf liegen, der der zweiten Gate-Elektrode E2a des mittleren Satzes von Speicherplätzen entspricht. Durch das erfindungsgemäße neuartige Verfahren und die Struktur wird das Ladungspaket 2 jedoch um die Strecke eines ganzen Bitsatzes von Speicherstellen so versetzt, daß der den Elektroden E1a, E2a, E3a und E4a entsprechende mittlere Satz von Speicherplätzen kurzgeschlossen wird. D.h., während der Phasen 2, 3 und 4 werden Ladungspakete aus den kurzgeschlossenen Speicherplätzen entsprechend den Elektroden E1a, E2a, E3a und E4a herausgenommen und somit wird während der parallelen Übertragung einer Zeile von Ladungspaketen in die erste Zeile der Matrix des parallelen Teiles kein Ladungspaket in die defekte Spalte entsprechend dem kurzgeschlossenen Satz von Speicherplätzen übertragen. Somit wird die defekte Spalte umgangen und außer Betrieb gesetzt.

Im Zusammenhang mit den Fign. 6 und 7 wird anschließend die Lage der Schnitte S2, S3, S4 und der Verbindungen F2, F3, F4 beschrieben. Die horizontal oben in diesen Figuren verlaufende Sammelleitung B2 ist aus Metall und hat einen nach unten verlaufenden Teil entsprechend der Leitung 2a. Horizontal unter der Sammelleitung B2 verläuft die Sammelleitung B1 aus Polysilicium. Die dritte horizontal verlaufende Sammelleitung B3 besteht ebenfalls aus Polysilicium und die unterste Sammelleitung B4 aus Metall. Die Sammelleitung B1 hat nach unten einen zur Leitung 1a führenden Teil, die Sammelleitung B3 einen nach oben zur Leitung 3a führenden Teil und die Sammelleitung B4 einen ebenfalls nach oben zur Leitung 4a und parallel neben dem Teil 3a verlaufenden Teil.

Nach Darstellung in Fig. 7 trennt der mit einem Laserstrahl ausgeführte Schnitt S2 den Teil 2a an einem Punkt zwischen der Sammelleitung B2 und der Sammelleitung B1. Der Schnitt S3 trennt den Teil 3a an einem Punkt unmittelbar neben der Sammelleitung B3. Der Schnitt F4 trennt den Teil 4a an einem Punkt unmittelbar neben der Sammelleitung B4. Die Verbindung F2 wird durch einen Laserstrahl hergestellt, der die Leiterbahn zwischen dem Teil 2a und der Sammelleitung B1 zusammenschmilzt. Der Laserstrahl bildet auch die Verbindung F3 durch Schmelzen einer Leiterbahn zwischen dem Teil 4a und einem seitlich verlaufenden Teil 3a. Der Laserstrahl bildet auch die Verbindung F4 durch Schmelzen einer Leiterbahn zwischen dem oberen Ende des Teiles 4a und der Sammelleitung B1.

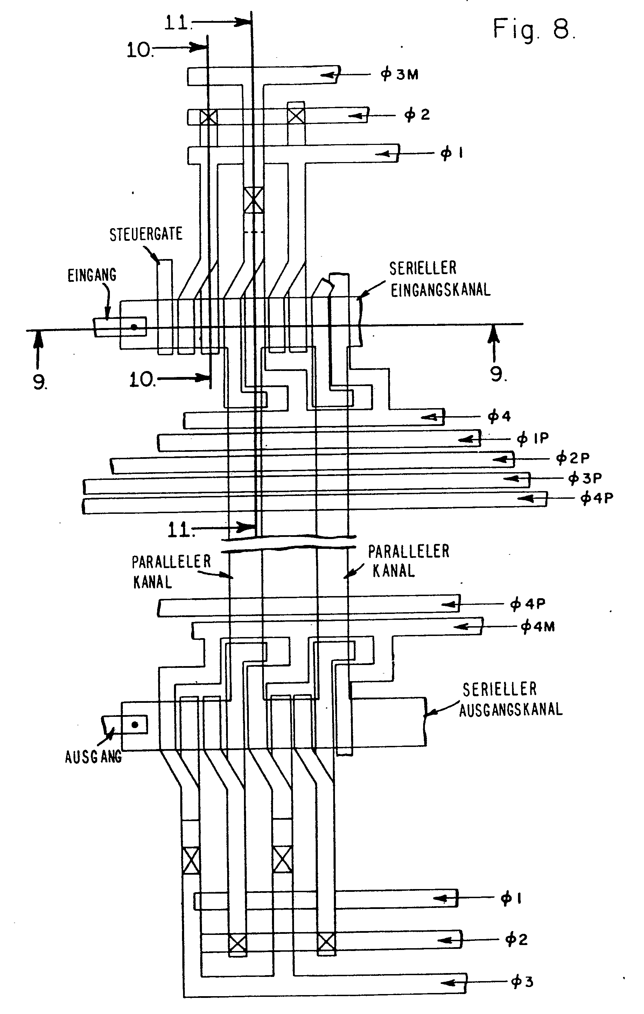

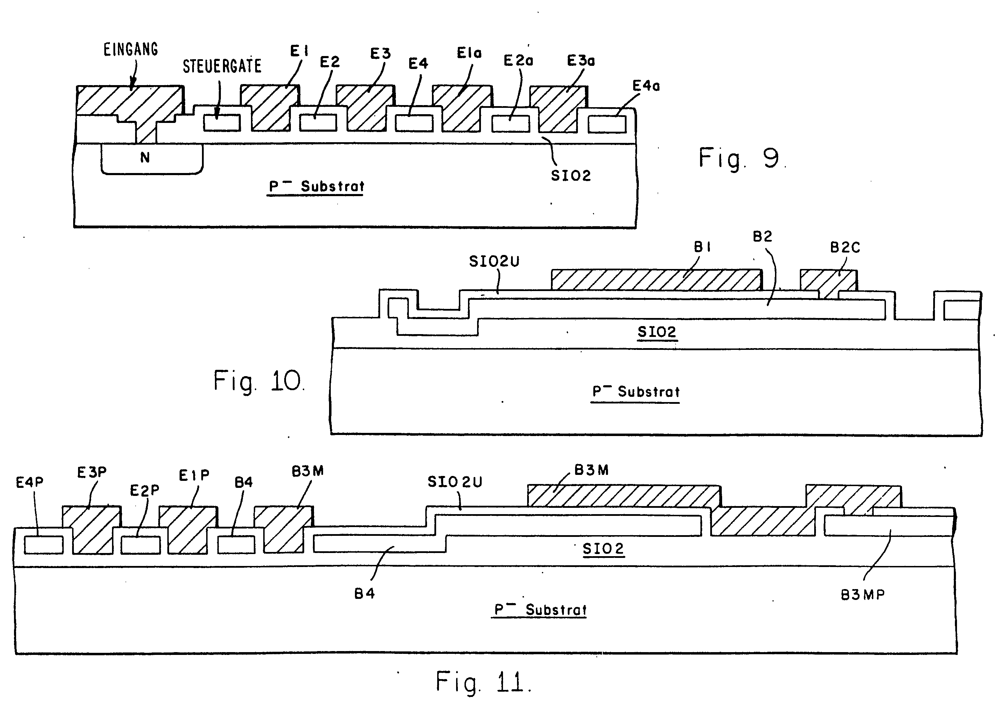

In den Fign. 8 und 9 ist der physikalische Aufbau des seriellen Eingangsteiles herkömmlicher Art gezeigt. Auf der linken Seite der Fig. 9 ist der Dateneingangsteil mit einer nach unten durch die Siliciumdioxidschicht zu einem N-leitenden Diffusionsbereich verlaufenden Metallverbindung dargestellt. Neben diesem N-leitenden Diffusionsbereich befindet sich eine Steuerelektrode vorzugsweise aus Polysilicium, die in der Siliciumdioxidschicht vergraben ist. Die erste Gate-Elektrode E1 besteht darstellungsgemäß aus Metall, die zweite Gate-Elektrode E2 aus Polysilicium. In ähnlicher Weise sind die nachfolgenden, ungeradzahligen Gate-Elektroden E3, E1a, E3a aus Metall und die geradzahligen E4, E2a, E4a aus Polysilicium und in der Siliciumdioxidschicht aus SIO2 eingebettet.

Fig. 10 ist zusammen mit Fig. 8 zu betrachten. Fig. 10 zeigt das Substrat, dessen Oberfläche durch die isolierende Siliciumdioxidschicht SIO2 gebildet wird. Diese hat einen obersten Teil SIO2U, der über der aus Polysilicium bestehenden Sammelleitung B2 liegt, die somit in der Siliciumdioxidschicht begraben ist. Ein Metallkontakt B2C verläuft nach unten durch die obere Siliciumdioxidschicht SIO2U und berührt die aus Polysilicium bestehende Sammelleitung B2. Die Metallsammelleitung B1 liegt über der oberen Fläche der Siliciumdioxidschicht SIO2U.

Fig. 11 ist im Zusammenhang mit Fig. 8 zu betrachten. Fig. 11 zeigt einen Satz von vier Gate-Elektroden E1P, E2P, E3P, E4P, die vier aufeinanderfolgende zusammenhängende Speicherplätze für Ladungspakete in einer der Spalten oder Kanäle des parallelen Teiles bilden. Die geradzahligen parallelen Gate-Elektroden wie E2P und E4P bestehen aus Polysilicium, das in der isolierenden Siliciumdioxidschicht SIO2 liegt, und die ungeradzahligen Gate-Elektroden des parallelen Teiles wie E1P und E3P bestehen aus Metall. Die aus Polysilicium bestehende Sammelleitung B4 ist in Fig. 10 in der isolierenden Siliciumdioxidschicht SIO2 eingebettet, unter deren oberen Teil SIO2U dargestellt. Die Bezeichnungen B3M und B3MP gelten für Sammelleitungen aus Metall bzw. Polysilicium für die nachfolgend beschriebenen Taktsignale Ø3M.

Nach Darstellung in Fig. 8 werden die vier Taktsignale Ø1, Ø2, Ø3, Ø4 für den seriellen Eingabe- und den Ausgabeteil an die entsprechenden Sammelleitungen angelegt. An die Sammelleitungen des parallelen Teiles werden die entsprechenden Taktsignale Ø1P, Ø2P, Ø3P, Ø4P angelegt. Im oberen Teil der Fig. 8 sind der serielle Eingangskanal mit dem Dateneingangsanschluß und dem Steuergate dargestellt. Der serielle Ausgangskanal mit seinem Datenausgangsanschluß ist im unteren Teil der Fig. 8 gezeigt. Der Mittelteil der Fig. 8 zeigt die Lage der parallelen Kanäle, die die Matrix von Ladungsspeicherplätzen des parallelen Teiles bilden.

In Fig. 8 sind zwei Taktsignale mit Ø3M und Ø4M bezeichnet. Das Taktsignal Ø3M ist eine modifizierte Version des Signales Ø3 und unterscheidet sich von diesem nur dadurch, daß es gleichzeitig mit dem Signal Ø4 zu dem Moment hochgeht, zu dem eine Zeile von Ladungspaketen parallel vom seriellen Eingabeteil in die erste Zeile der Matrix des parallelen Teiles übertragen wird. Ähnlich ist das Taktsignal Ø4M eine Modifikation des Taktsignales Ø4 und unterscheidet sich von diesem nur dadurch, daß es mit dem Signal Ø1 zu dem Zeitpunkt hochkommt, wenn eine Zeile von Ladungspaketen von der letzten Zeile des parallelen Teiles in den seriellen Ausgabeteil übertragen wird. Diese Taktsignale und die von ihnen ausgelösten Übertragungsoperationen sind durchaus herkömmlicher Art.

Während das oben beschriebene Ausführungsbeispiel der Einfachheit und Klarheit halber nicht verschachtelt ist, läßt sich die vorliegende Erfindung natürlich genauso gut auf eine verschachtelte Anordnung anwenden. Dabei entsprechen im allgemeinen zwei Spalten im parallelen Teil einer Bitlänge in den seriellen Teilen. Im Gegensatz dazu gibt es bei der nichtverschachtelten Organisation nur eine parallele Spalte, die einer Bitlänge der seriellen Teile entspricht. Bei der verschachtelten Organisation wird zuerst ein Zug von Ladungspaketen, die Einer-Bits darstellen (oder beim Fehlen von Ladungspaketen Null-Bits) in die erste Bitstelle in jeder zweiten Spalte des parallelen Teiles (z.B. in die ungeraden Spalten) übertragen und dort vorübergehend gespeichert. Dann wird ein anderer Zug von Ladungspaketen in die erste Bitstelle in die geradzahligen Spalten im parallelen Teil übertragen. Dann wird die Zeile von Ladungspaketen in allen parallelen Spalten von einer Zeile zur anderen übertragen.

Die vorliegende Erfindung wird in einer verschachtelten Konfiguration wie folgt verwirklicht. Für jede redundante Spalte im parallelen Teil muß jetzt ein Spaltenpaar im parallen Abschnitt betrachtet werden, d.h., ein Paar zusätzlicher redundanter Spalten ist als potentieller Ersatz für jedes defekte Spaltenpaar vorgesehen. Wenn eine der ein Paar bildenden parallelen Spalten bei der Prüfung sich als defekt erweist, dann können beide Spalten des Paares umgangen und ein redundantes Spaltenpaar für das defekte Paar eingesetzt werden. Auch bei der verschachtelten Konfiguration werden hierzu die entsprechenden Schnitte und Verbindungen mit einem Laserstrahl hergestellt.

## Patentansprüche

1. Ladungskopplungsspeicher, bei dem ein Strom von Datenbits in ein Schieberegister, das aus Ladungskopplungselementen mit Gate-Elektroden und darunterliegenden Potentialtöpfen besteht, eingegeben wird, das mit einem parallel ansteuerbaren Speicher zur Übertragung der Daten in diesen Speicher verbunden ist, wobei Speicherplätze innerhalb des parallelen Speichers defekt sind und wenigstens eine redundante Spalte angeordnet ist, wobei durch Kurzschließen von Gruppen oder Sätzen serieller Register (z.B. 15), die jeder defekten Spalte (C5) entsprechen, ein Ersatz erfolgt, und bei dem eine entsprechende Anzahl redundanter Spalten entsprechend der Anzahl defekter Spalten im parallelen Speicher ansteuerbar sind, sowie Taktphasenleitungen zur Steuerung in mehreren Phasen vorhanden sind, dadurch gekennzeichnet, daß das Kurzschließen der defekten Spalten (C5) durch Verbinden aller Gate-Elektroden (E1a, E2a, E3a, E4a) der Gruppe mit einer Taktphasenleitung (z.B. E1) erfolgt, um die defekte Spalte (z.B. C5) zu umgehen, wobei bei jeder Gate-Elektrode (E2a, E3a, E4a) die sie im fehlerfreien Zustand mit einer individuellen Taktphasenleitung (B2, B3, B4) verbindende Leitung (2a, 3a, 4a) durchgetrennt wird und der noch mit der Gate-Elektrode (E2a, E3a, E4a) verbundene Teil der Leitung (2a, 3a, 4a) mit der einen kreuzenden Taktphasenleitung (B1) am Kreuzungspunkt (F2, F3, F4) verbunden wird.

2. Ladungskopplungsspeicher nach Anspruch 1, dadurch gekennzeichnet, daß bei einer vierphasigen Anordnung mit den Phasen Ø1—Ø4 die normalen Verbindungen der drei Gate-Elektroden (E2a, E3a, E4a) mit den Phasen Ø2, Ø3 und Ø4 mit ihren entsprechenden Taktphasenleitungen (B2 bis B4) aufgetrennt werden und statt dessen mit einer Taktphasenleitung (B1), die der Phase Ø1 zugeordnet ist, verbunden werden.

3. Verfahren zur Herstellung eines Ladungskopplungsspeichers, wobei vor Fertigstellung dieses Ladungskopplungsspeichers ein Prüfvorgang eingeschaltet wird, der feststellt, ob der parallele Speicherteil Spalten mit defekten Bitstellen enthält und in einem Anschlußprozeß die defekten Spalten herausgenommen werden und statt dessen eine entsprechende Anzahl redundanter Spalten eingesetzt wird, nach Anspruch 2, dadurch gekennzeichnet, daß die normalen Verbindungen (2a bis 4a) der Gate-Elektroden (E2a bis E4a) mit den Phasen Ø2, Ø3 und Ø4 bei einer vierphasigen Anordnung mit den Phasen Ø1 bis Ø4 und ihren entsprechenden Taktleitungen (B2 bis B4) durch einen Laserstrahl aufgetrennt werden und statt dessen mit einer anderen kreuzenden Taktphasenleitung (B1), die der Phase Ø1 zugeordnet ist,

ebenfalls mit Hilfe eines Laserstrahls verbunden werden.

## Claims

1. Charge-coupled memory, wherein a stream of data bits is entered in a shift register which consists of a series of charge-coupled elements with gate electrodes and potential wells therebeneath, and which is connected to a parallel-controlled storage for transferring the data in parallel into this storage, at least one column of storage locations within the parallel storage being defective and at least one redundant column being provided, with a replacement being effected through short-circuiting groups or sets of serial registers (e.g. 15) corresponding to each defective column (C5), and wherein a corresponding number of redundant columns corresponding to the number of defective columns are controllable in the parallel storage, and wherein clock phase lines are provided for multi-phase control, characterized in that the short-circuiting of the defective columns (C5) is effected by connecting all the gate electrodes (E1a, E2a, E3a, E4a) of the group with a common clock phase line (e.g. B1) to bypass a defective column (e.g. C5), the line (2a, 3a, 4a) for each gate electrode (E2a, E3a, E4a) connecting it in its non-defective state to an individual clock phase line (B2, B3, B4) being interrupted, and that part of the line (2a, 3a, 4a) that is still connected to the gate electrode (E2a, E3a, E4a) being connected to the clock phase line (B1) at the point of intersection (F2, F3, F4).

2. Charge-coupled device as claimed in claim 1, characterized in that in a four-phase arrangement with the phases Ø1—Ø4 the standard connections of the three gate electrodes E2a, E3a, E4a with the phases Ø2, Ø3 and Ø4 with their corresponding clock phase lines (B2 to B4) are disconnected, and that instead they are connected to a clock phase line (B1) associated to phase Ø1.

3. Method of making a charge-coupled storage, wherein prior to the completion of this charge-coupled storage a test process is inserted to determine whether the parallel storage comprises columns with defective bit positions, and wherein in a subsequent process the defective columns are removed and a corresponding number of redundant columns are inserted instead, as claimed in claim 2, characterized in that the standard connections (2a to 4a) of the gate electrodes (E2a to E4a) with the phases Ø2, Ø3, and Ø4 in a four-phase arrangement with phases Ø1 to Ø4, and their corresponding clock lines (B2 to B4) are disconnected by means of a laser beam, and that instead, by means of another intersecting clock phase line (B1) associated to phase Ø1, they are connected also by means of a laser beam.

## Revendications

1. Mémoire à charges couplées, dans laquelle un courant de bit de données est introduit dans un registre à décalage qui est composé d'éléments à charges couplées avec des électrodes de porte et des puits de potentiel sousjacents et qui est connecté avec une mémoire parallèle adressable pour transférer les données dans cette mémoire, ladite mémoire parallèle comportant des positions de mémoire défectueuses et prévoyant au moins une colonne redondante, dans laquelle on fait les remplacements en court-circuitant des groupes ou des jeux de registres à décalage par (exemple 15) correspondant à chaque colonne défectueuse (C5), et dans laquelle un nombre de colonnes redondantes correspondant au nombre des colonnes défectueuses dans la mémoire parallèle est adressable et qui comporte des lignes de phase de chronologie pour une commande multi-phases, cette mémoire à charges couplées étant caractérisée en ce que les colonnes défectueuses (C5) sont court-circuitées en connectant toutes les électrodes de porte (E1a, E2a, E3a, E4a) du groupe avec une ligne de phase de chronologie (par exemple E1) pour contourner la colonne défectueuse (par exemple C5), et en ce que la ligne (2a, 3a, 4a) qui connecte chaque électrode de porte (E2a, E3a, E4a) dans l'état non défectueux avec une ligne de phase de chronologie individuelle (B2, B3, B4) est déconnectée, la partie de la ligne (2a, 3a, 4a) qui est encore connectée avec l'électrode de porte (E2a, E3a, E4a) étant connectée au point d'intersection (F2, F3, F4) avec la ligne de phase de chronologie sécante (B1).

2. Mémoire à charges couplées selon la revendication 1, caractérisée en ce que dans un dispositif à quatre phases avec les phases Ø1 à Ø4 les trois électrodes de porte E2a, E3a, E4a avec les phases Ø2, Ø3 et Ø4 qui sont normalement connectées avec leurs lignes de phase de chronologie correspondantes (B2 à B4) sont déconnectées pour être connectées à la ligne de phase de chronologie (B1) associée à la phase Ø1.

3. Procédé pour fabriquer une mémoire à charges couplées dans lequel on insère, avant la finition de cette mémoire à charges couplées, une étape d'essai pour déterminer si la partie de mémoire parallèle contient des colonnes avec des positions de bit défectueuses et dans lequel on enlève dans une étape ultérieure les colonnes défectueuses pour les remplacer par un nombre correspondant de colonnes rédondantes, selon la revendication 2, caractérisé en ce que les connexions normales (2a à 4a) des électrodes de porte (E2a à E4a) avec les phases Ø2, Ø3 et Ø4 dans le cas d'un dispositif a quatre phases Ø1 à Ø4 et leurs lignes de chronologie (B2 à B4) correspondantes, sont rompues à l'aide d'un faisceau laser pour être connectées avec une autre ligne de phase de chronologie sécante (B1) associée à la phase Ø1, et ceci également à l'aide d'un faisceau laser.

0 006 470

Fig. 1

Fig. 2.

Fig. 3.

φ4 → B4
φ3 → B3  S4 ⊕ 4a  4b
φ2 → B2  4
  B1  3  S3 ⊕ 3a  3b
φ1 →  2  S2 ⊕ 2a  F4  2b
  1  1a  F2  F3  1b

E1 E2 E3 E4 E1a E2a E3a E4a E1b E2b E3b E4b

SIO2  P⁻ Substrat

0 006 470

POTENTIAL-HÖHE

LADUNGSPAKET 1  LADUNGSPAKET 2

Fig. 4.
(Phase 1)

POTENTIAL-HÖHE

LADUNGSPAKET 1  LADUNGSPAKET 2

Fig. 5.
(Phase 2)

## Fig. 6.

## Fig. 7.

0 006 470

Fig. 8.

STEUERGATE

EINGANG

SERIELLER EINGANGSKANAL

$\phi 3M$

$\phi 2$

$\phi 1$

$\phi 4$

$\phi 1P$

$\phi 2P$

$\phi 3P$

$\phi 4P$

PARALLELER KANAL

PARALLELER KANAL

$\phi 4P$

$\phi 4M$

SERIELLER AUSGANGSKANAL

AUSGANG

$\phi 1$

$\phi 2$

$\phi 3$

4

EINGANG

STEUERGATE E1 E2 E3 E4 E1a E2a E3a

E4a

N

P⁻ Substrat

SIO2

Fig. 9.

SIO2U B1 B2 B2C

SIO2

Fig. 10.

P⁻ Substrat

E4P E3P E2P E1P B4 B3M SIO2U B3M

B4 SIO2

SIO2

P⁻ Substrat B3MP

Fig. 11.